# EUROPÄISCHE PATENTSCHRIFT

(11) **EP 3 046 811 B1**
(45) Veröffentlichungstag und Bekanntmachung des Hinweises auf die Patenterteilung: **19.06.2019**
(21) Anmeldenummer: 14748109.7
(22) Anmeldetag: 17.07.2014
(51) Int. Cl.: B60R 16/023, H01R 12/70, H05K 5/00

(54) **KONTAKTSYSTEM FÜR STECKVERBINDUNGEN AN ELEKTRONIKGEHÄUSEN**
CONTACT SYSTEM FOR PLUG-IN CONNECTIONS ON ELECTRONICS HOUSINGS
SYSTÈME DE CONTACT POUR CONNEXIONS ENFICHABLES SUR DES BOÎTIERS ÉLECTRONIQUES

(30) Priorität: 19.09.2013 DE 102013015593
(43) Veröffentlichungstag der Anmeldung: 27.07.2016
(73) Patentinhaber: WABCO GmbH, 30453 Hannover (DE)
(72) Erfinder: KORTLANG, Tobias, 30989 Gehrden (DE)
(74) Vertreter: Lauerwald, Jörg
(86) Internationale Anmeldenummer: PCT/EP2014/001947
(87) Internationale Veröffentlichungsnummer: WO 2015/039713

(56) Entgegenhaltungen:
- DE-A1-102011 085 921
- US-A- 5 236 098
- US-A1- 2002 055 286

## Beschreibung

Die Erfindung betrifft ein Kontaktsystem für Steckverbindungen an Elektronikgehäusen zur Kontaktierung von mechatronischen Bauelementen, beispielsweise von Steuermodulen, Magnetventilen, Sensoren oder Sicherungen von Kraftfahrzeugen, mit wenigstens einem als Stanzteil ausgebildeten, an einer Leiterplatte kontaktierten sowie aus einem Gehäuse herausgeführten Kontaktelement.

In der DE 195 15 622 A1 ist ein Steuermodul von Kraftfahrzeugen offenbart. Ein Getriebesteuergerät des Steuermoduls besteht aus einer beispielsweise als Kühlkörper ausgebildeten Grundplatte, einem beispielsweise durch Aufkleben mit der Grundplatte thermisch und mechanisch verbundenen, als Leiterplatte ausgebildeten Trägerkörper, einer auf dem Trägerkörper angeordneten Dickschicht-Schaltungsanordnung mit einer Vielzahl von mittels einer Vergussmasse vergossenen passiven und aktiven SMD-Halbleiterbauelementen, einem Gehäusekörper, der die Schaltungsanordnung zum Schutz der Halbleiterbauelemente umschließt, mehreren in den Gehäusekörper nebeneinander und übereinander integrierten und mit der Schaltungsanordnung beispielsweise über Bonddrähte verbundenen Stanzgittern, die eine unterschiedliche Anzahl von Stanzgitteranschlüssen aufweisen können, und einem Anschlussstecker, über den das Getriebesteuergerät bzw. das Steuermodul mittels Verbindungsleitungen mit dem Getriebe verbunden ist, so dass das Getriebe mit dem Ausgangssignal des Steuermoduls bzw. des Getriebesteuergeräts als Steuersignal beaufschlagbar ist. Mehrere der Stanzgitter dienen dabei zur Bildung eines Anschlusssteckers des Getriebe-Steuergeräts, die restlichen Stanzgitter zur Aufnahme und Kontaktierung von Sensoren und Aktuatoren. Die leitende Verbindung zwischen den Aktuatoren und dem Getriebe-Steuergerät erfolgt mittels direkter Kontaktierung der an ihrem Ende Gabelelemente/Federelemente aufweisenden Stanzgitteranschlüsse des entsprechenden Stanzgitters.

Bei dieser Anordnung werden Steckkräfte nachteilig direkt auf die Leiterplatte übertragen. Außerdem ist der Zusammenbau kompliziert, da es ein mehrfaches Biegen des Stanzgitters sowie die Montage der Einzelkomponenten mit einem hohen Automatisierungsgrad erfordert. Schließlich ist die Kontaktierung der Leiterplatte auf ein bestimmtes Herstellverfahren beschränkt, nämlich das Bonden.

DE 10 2011 085 921 A1 offenbart einen Kontaktadapter zum kraftoptimierten Kontaktieren eines elektrischen Verbrauchers an eine Leiterplatte. Der Kontaktadapter weist ein elektrisch leitfähiges Kontaktelement und eine elektrisch nitcht leitfähige Haltestruktur auf. Das elektrisch leitfähige Kontaktelement ist ausgeführt, einen elektrischen Kontakt zwischen der Leiterplatte und dem elektrischen Verbraucher herzustellen. Die Haltestruktur weist eine erste Auflagefläche auf, die ausgeführt ist an einer Trägerplatte der Leiterplatte anzuliegen. Dabei ist das Kontaktelement, derart in die Haltestruktur integriert, dass eine durch den elektrischen

Verbraucher auf das Kontaktelement ausgeübte erste Kraft über die erste Auflagefläche auf die Trägerplatte der Leiterplatte übertragbar ist.

US 2002/0055286 A1 offenbart ein Kontaktelement zur elektrischen Verbindung einer Leiterplatte.

Vor diesem Hintergrund liegt der Erfindung die Aufgabe zugrunde, ein Kontaktsystem für Steckverbindungen an Elektronikgehäusen vorzuschlagen, das einen flexiblen Ausgleich von Relativbewegungen ermöglicht, kostengünstig herstellbar ist und eine einfache Montage ermöglicht, die an unterschiedlichen Standorten durchführbar ist.

Gelöst wird diese Aufgabe mit einem Kontaktsystem gemäß den Merkmalen des Anspruchs 1.

Gemäß einer vorteilhaften Ausführungsform ist vorgesehen, dass das wenigstens eine Kontaktelement wenigstens einen Verbindungssteg aufweist, dass in Bezug zu dem wenigstens einen Verbindungssteg an dem Kontaktelement eine um etwa 90° abgebogene erste Kontaktfahne mit einen Ausschnitt ausgebildet ist, dass an der ersten Kontaktfahne Kontaktvorsprünge ausgebildet sind, die in den Ausschnitt hineinragen, dass wenigstens eine in Bezug zum wenigstens einen Verbindungssteg um etwa 90° abgebogene zweite Kontaktfahne an dem Kontaktelement ausgebildet ist, und dass die beiden Kontaktfahnen durch den wenigstens einen Verbindungssteg verbunden sind.

Das wenigstens eine Kontaktelement ist somit ein gesondert herstellbares Bauteil, das sich an einer Grundplatte des Elektronikgehäuses durch Einstecken sowie Verrasten befestigen lässt, und welches durch die Verbindung der ersten Kontaktfahne mit der zweiten Kontaktfahne mittels eines Verbindungssteges einen flexiblen Ausgleich der Steckkräfte ermöglicht. Ein solches Kontaktelement lässt sich auf einfache Weise als Stanzteil aus einer Blechtafel herstellen und unabhängig von der Montage der übrigen Bauelemente im Elektronikgehäuse montieren.

Der wenigstens eine Verbindungssteg kann gerade verlaufend zwischen der ersten Kontaktfahne und der zweiten Kontaktfahne ausgebildet sein, verläuft jedoch vorzugsweise zickzackförmig oder wellenförmig, um eine möglichst optimale Flexibilität für den Ausgleich von Relativbewegungen des Kontaktelementes zu ermöglichen.

Für eine gute Verrastung des Kontaktelements mit der Grundplatte kann vorgesehen sein, dass an der ersten Kontaktfahne Rastvorsprünge angeordnet sind, die von den Kontaktvorsprüngen mit ihrem freien Ende wegweisen.

Weiter kann vorgesehen sein, dass die zweite Kontaktfahne aus zwei parallelen, um 90° abgebogenen Kontaktlappen gebildet ist, und dass zwischen den beiden Kontaktlappen eine Rastfläche und/oder beiderseits der beiden Kontaktlappen sowie von diesen mit ihrem freien Ende wegweisende Rastvorsprünge angeordnet sind, welche ebenfalls zur Verrastung mit der Grundplatte dienen.

Beispielsweise ist die wenigstens einteilige zweite Kontaktfahne dazu eingerichtet, die Leiterplatte durch Einpressen oder Löten zu kontaktieren. Zur Ausrichtung des Kontaktelements gegenüber der Leiterplatte ist benachbart zur wenigstens einteiligen zweiten Kontaktfahne des Kontaktelements eine Ausnehmung zur Aufnahme eines Positionierzapfens ausgebildet.

Unabhängig davon oder im Zusammenwirken mit dem Positionierzapfen und der Ausnehmung im Kontaktelement zur Aufnahme desselben kann vorgesehen sein, dass das Elektronikgehäuse zur Montage in eine Vorrichtung eingelegt wird, die durch entsprechende Ausbildung im Kontaktbereich die Kontakte positioniert. Danach wird die Leiterplatte von oben in das Elektronikgehäuse eingelegt, dabei über die Vorrichtung und/oder das Elektronikgehäuse positioniert und in das Elektronikgehäuse gepresst.

Die Verrastung des Kontaktelements mit der Grundplatte erfolgt erfindungsgemäß in der Weise, dass die Grundplatte für die Aufnahme der ersten Kontaktfahne des Kontaktelements einen Kontakthalter aufweist, der auf einer zu einer Einführfase für einen Steckkontakt entgegengesetzten Seite der Grundplatte angeordnet ist, dass benachbart dazu an der Grundplatte eine erste Auszugssicherung angeordnet ist, deren Rastvorsprünge die Rastvorsprünge an der ersten Kontaktfahne übergreifen, und dass an der Grundplatte für die zweite Kontaktfahne des Kontaktelements eine zweite Auszugssicherung mit wenigstens einer Rastnase ausgebildet ist, welche die Rastfläche und/oder die beiden Rastvorsprünge an der zweiten Kontaktfahne übergreift.

Je nach Ausführungsart des Elektronikgehäuses können die erste Kontaktfahne und die wenigstens einteilige zweite Kontaktfahne gleichsinnig um etwa 90° in Richtung zur Leiterplatte abgebogen sein, oder es kann die erste Kontaktfahne entgegengesetzt zur wenigstens einteiligen zweiten Kontaktfahne um etwa 90° entgegengesetzt zur Leiterplatte abgebogen ausgebildet sein.

Die Erfindung wird nachstehend anhand zweier in der Zeichnung dargestellter Ausführungsbeispiele weiter erläutert. In der Zeichnung zeigt
Fig. 1 einen Querschnitt durch ein Elektronikgehäuse im Bereich eines Kontaktelements gemäß dem erfindungsgemäßen Kontaktsystem,
Fig. 2 einen Längsschnitt durch das Elektronikgehäuse gemäß Fig. 1 entlang der Linie II-II,
Fig. 3 eine vergrößerte perspektivische Darstellung eines Kontaktelements gemäß einer ersten Ausführungsform,
Fig. 4 eine vergrößerte Teilschnittansicht des Elektronikgehäuses gemäß Fig. 1 im Bereich eines Kontaktelements gemäß den Figuren 1 bis 3,
Fig. 5 eine vergrößerte Teilschnittansicht des Elektronikgehäuses gemäß Fig. 2 im Bereich eines Kontaktelements gemäß den Figuren 1 bis 4, und
Fig. 6 eine vergrößerte Teilschnittansicht des Elektronikgehäuses mit einem gemäß der Erfindung ausgebildeten Kontaktelements in einer zweiten Ausführungsform.

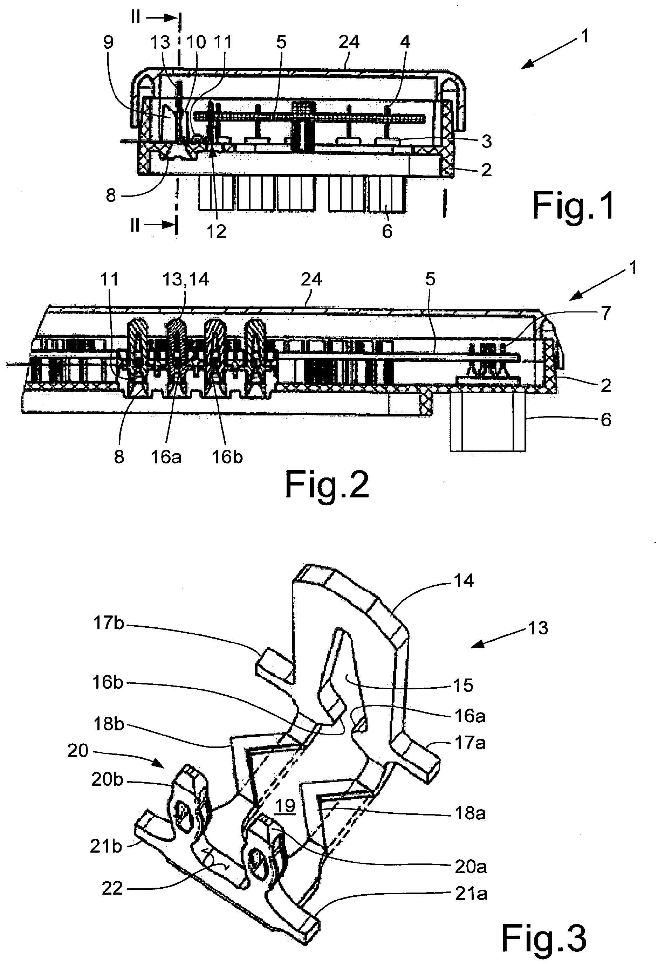

Das in den Figuren 1 und 2 dargestellte Elektronikgehäuse 1 weist eine Grundplatte 2 auf, an der verschiedene Elektronikelemente 3 angeordnet sind, sowie einen Gehäusedeckel 24, welcher das Elektronikgehäuse 1 hermetisch abschließt. Die Elektronikelemente 3 sind mittels Kontaktstifte 4 mit einer darüber angeordneten Leiterplatte 5 in bekannter Weise durch Löten elektrisch leitend verbunden. Eine im Einzelnen nicht dargestellte Steckerbuchse 6 dient zur Verbindung der Elektronikelemente 3 beziehungsweise der Leiterplatte 5 mit einem nicht dargestellten elektronischen Steuersystem eines Kraftfahrzeugs. Hierzu sind Kontaktstifte 7 der Steckerbuchse 6 mit der Leiterplatte 5 elektrisch leitend verbunden.

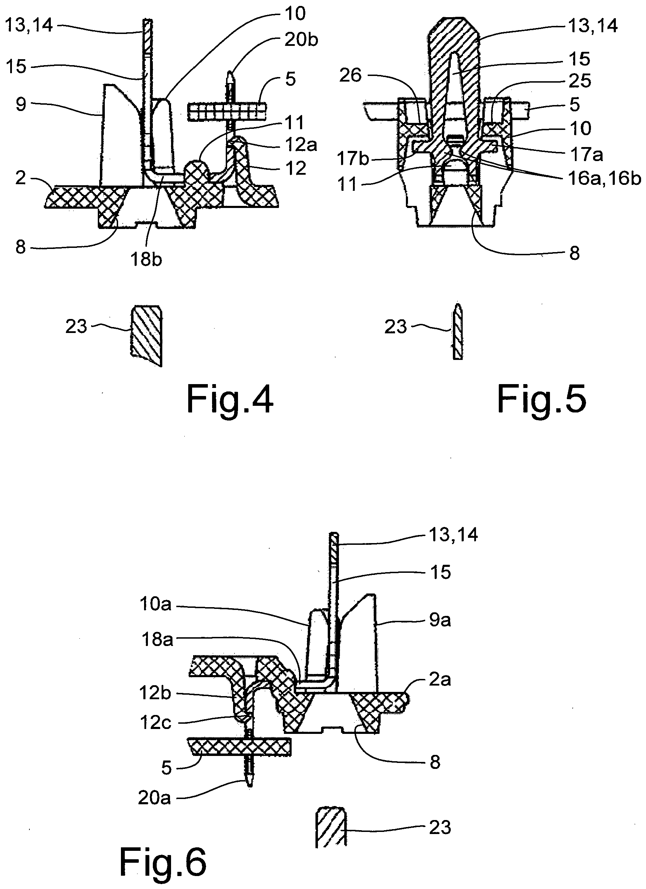

Auf der Unterseite der Grundplatte 2 sind mehrere Einführfasen 8 zur Aufnahme von in den Figuren 4 bis 6 schematisch dargestellten Steckkontakten 23 vorgesehen, die an zu kontaktierenden mechatronischen Bauelementen ausgebildet sind. Diese mechatronischen Bauelemente sind selbst nicht dargestellt. Auf der der Leiterplatte 5 zugewandten Seite der Grundplatte 2 sind ein Kontakthalter 9 und benachbart dazu eine erste Auszugssicherung 10, ein Positionierzapfen 11 und eine zweite Auszugssicherung 12, vorzugsweise materialeinheitlich mit der Grundplatte 2, angeordnet.

Die erste Auszugssicherung 10 an der Grundplatte 2 weist Rastvorsprünge 25, 26 auf, die mit ihren freien Enden unter Wahrung eines Abstands radial gegeneinander gerichtet sind und zum Halten einer ersten Kontaktfahne 14 eines Kontaktelements 13 an der Grundplatte 2 dienen. Die zweite Auszugssicherung 12 an der Grundplatte 2 weist wenigstens eine Rastnase 12a auf, die zum Verrasten und Positionieren des als Stanzteil aus Metall hergestellten Kontaktelements 13 dienen. Wie insbesondere der perspektivischen Darstellung in Fig. 3 entnehmbar ist, weist dieses Kontaktelement 13 eine erste, um 90° abgebogene Kontaktfahne 14 auf, die mit einem Ausschnitt 15 versehen ist, in den zwei Kontaktvorsprünge 16a, 16b ragen, zwischen denen der Steckkontakt 23 elektrisch leitend einklemmbar ist. Entgegengesetzt zu den beiden Kontaktvorsprüngen 16a, 16b sind an der ersten Kontaktfahne 14 zwei Rastvorsprünge 17a, 17b angeordnet, die von den Rastvorsprüngen 25, 26 an der ersten Auszugssicherung 10, übergriffen werden, wie insbesondere in Fig. 5 dargestellt ist.

Das in Fig. 3 dargestellte Ausführungsbeispiel des Kontaktelements 13 zeigt, dass deren zweites Kontaktelement 20 aus zwei Kontaktlappen 20a, 20b gebildet ist, die parallel zueinander angeordnet sowie um 90° parallel zur ersten Kontaktfahne 14 an dem Kontaktelement 13 abgebogen ausgebildet sind.

Die erste Kontaktfahne 14 und die beiden Kontaktlappen 20a, 20b sind mittels zwei Verbindungsstege 18a, 18b verbunden, so dass das gesamte Kontaktelement 13 aus der ersten Kontaktfahne 14, den beiden Verbindungsstegen 18a, 18b und der zweiteiligen zweiten Kontaktfahne 20 mit deren beiden Kontaktlappen 20a, 20b gebildet ist. Die beiden Verbindungsstege 18a, 18b sind zickzackförmig ausgebildet, um die Verbindung zwischen der ersten Kontaktfahne 14 und den beiden Kontaktlappen 20a, 20b der zweiten Kontaktfahnen 20 möglichst flexibel zu gestalten. Gestrichelt ist eine weitere Variante mit gerade ausgebildeten Verbindungsstegen dargestellt. Ebenso ist es möglich, die Verbindungsstege 18a, 18b gebogen oder gewellt auszuführen, um den jeweils gewünschten Grad an Flexibilität zu erreichen.

Zwischen dem Paar der Verbindungsstege 18a, 18b der zweiten Kontaktfahne 20 ist eine Rastfläche 22 für die Rastnase 12a an der zweiten Auszugssicherung 12 vorgesehen. Zusätzlich sind seitlich abstehende Rastvorsprünge 21a, 21b, die in etwa gleich gerichtet zu den Rastvorsprüngen 17a, 17b an der ersten Kontaktfahne 14 verlaufen, dargestellt, welche ebenfalls von Rastnasen, ähnlich der Rastnase 12a an entsprechenden Auszugssicherungen, parallel zu der dargestellten zweiten Auszugssicherung 12 angeordnet sein können.

Das Kontaktelement 13 lässt sich, wie aus den Figuren 4 und 5 ersichtlich ist, von oben mit kommend der Grundplatte 2 verrasten und wird dabei durch einen Positionierzapfen 11 an der Grundplatte 2 positioniert. Dazu greift der der Positionierzapfen 11 in eine Positionierausnehmung 19 ein, die benachbart zu den Verbindungsstegen 18a, 18b ausgebildet ist (Fig. 3). Danach wird die Leiterplatte 5 auf die Grundplatte 2 von oben aufgesetzt, wobei die Kontaktstifte 4 der Elektronikelemente 3 sowie die Kontaktlappen 20a, 20b durch entsprechende Öffnungen in der Leiterplatte 5 hindurchgeführt werden und diese durch den Einpressvorgang oder durch ein zusätzliches Verlöten kontaktieren.

Aus den Figuren 1 bis 5 ergibt sich, dass die Kontaktierung der ersten Kontaktfahne 14 mit dem Steckkontakt 23 an einem zu kontaktierenden mechatronischen Bauelement von der Unterseite der Grundplatte 2 aus erfolgt, wobei die Oberseite der Grundplatte 2 dem Inneren des Elektronikgehäuses 1 zugewandt ist und durch den Gehäusedeckel 24 abgedeckt ist. Bei dieser Ausführungsform sind die erste Kontaktfahne 14 und das Paar der Kontaktlappen 20a, 20b der zweiten Kontaktfahnen 20 gleichsinnig sowie parallel zueinander um 90° abgebogen.

Fig. 6 zeigt eine Variante, bei der die erste Kontaktfahne 14 und das Paar der Kontaktlappen 20a, 20b der zweiten Kontaktfahnen 20 entgegengesetzt zueinander gerichtet sowie parallel um 90° abgebogen sind. In diesem Fall ist die Grundplatte 2a zur Verrastung des Kontaktelements 13 wie in Fig. 6 dargestellt ausgebildet, wobei in diesem Fall die Grundplatte 2a zwischen zwei gegenüberliegenden, nicht dargestellten Gehäusedeckeln angeordnet ist. Die erste Kontaktfahne 14 ist dabei an der Oberseite der Grundplatte 2a zwischen einem ersten Kontakthalter 9a und einer ersten Abzugsicherung 10a angeordnet. Die zweiteilig ausgebildete zweite Kontaktfahne 20; 20a, 20b ist durch eine nicht sichtbare Öffnung in der Grundlatte 2a zur Unterseite derselben hindurchgeführt. An der Unterseite der Grundplatte 2a ist eine zweite Abzugssicherung 12b angeordnet, deren Rastnase 12c in die zweite Kontaktfahne 20; 20a, 20b eingreift. Erkennbar ist bei diesem Aufbau die Leiterplatte 5 an der Unterseite der Grundplatte 2a platziert und wird dort von der zweite Kontaktfahne 20; 20a, 20b kontaktiert.

Es ist ersichtlich, dass das erfindungsgemäße Kontaktsystem für Steckverbindungen an Elektronikgehäusen eine lösbare Kontaktierung von mechatronischen Bauelementen ermöglicht, die einen flexiblen Ausgleich von Relativbewegungen des Kontaktes gewährleistet, kostengünstig herstellbar ist und die Möglichkeit der Verarbeitung an verschiedenen Standorten ohne die Nutzung von speziellen technischen Vorrichtungen gewährleistet.

## Patentansprüche

1. Kontaktsystem für Steckverbindungen an Elektronikgehäusen (1) zur Kontaktierung von mechatronischen Bauelementen, beispielsweise von Steuermodulen, Magnetventilen, Sensoren oder Sicherungen von Kraftfahrzeugen, mit einer Grundplatte (2) des Elektronikgehäuses und mit wenigstens einem als Stanzteil ausgebildeten, an einer Leiterplatte (5) kontaktierten sowie aus einem Elektronikgehäuse (1) herausgeführten Kontaktelement (13), wobei das wenigstens eine Kontaktelement (13) dazu ausgebildet ist,
a) an der Grundplatte (2) des Elektronikgehäuses (1) durch Einstecken und Verrasten befestigt zu werden,
b) mit einer ersten Kontaktfahne (14) einen Steckkontakt (23) eines mechatronischen Bauelements zu kontaktieren, und
c) mit einer zweiten Kontaktfahne (20; 20a, 20b) die Leiterplatte (5) zu kontaktieren, **dadurch gekennzeichnet, dass** die Grundplatte (2) zur Aufnahme einer ersten Kontaktfahne (14) des Kontaktelements (13) einen Kontakthalter (9) aufweist, der auf einer zu einer Einführfase (8) für einen Steckkontakt (23) entgegengesetzten Seite der Grundplatte (2) angeordnet ist, dass benachbart dazu an der Grundplatte (2) eine erste Auszugssicherung (10) angeordnet ist, deren Rastvorsprünge (25, 26) die Rastvorsprünge (17a, 17b) an der ersten Kontaktfahne (14) übergreifen, und dass an der Grundplatte (2) für die zweite Kontaktfahne (20; 20a, 20b) des Kontaktelements (13) eine zweite Auszugssicherung (12) mit wenigstens einer Rastnase (12a) ausgebildet ist, welche die Rastfläche (22) und/oder die beiden Rastvorsprünge (21a, 21b) an der zweiten Kontaktfahne (20; 20a, 20b) übergreift.

2. Kontaktsystem nach Anspruch 1, **dadurch gekennzeichnet, dass** das wenigstens eine Kontaktelement (13) wenigstens einen Verbindungssteg (18a, 18b) aufweist, dass in Bezug zu dem wenigstens einen Verbindungssteg (18a, 18b) an dem Kontaktelement (13) eine um etwa 90° abgebogene erste Kontaktfahne (14) mit einen Ausschnitt (15) ausgebildet ist, dass an der ersten Kontaktfahne (14) Kontaktvorsprünge (16a, 16b) ausgebildet sind, die in den Ausschnitt (15) hineinragen, dass wenigstens eine in Bezug zum wenigstens einen Verbindungssteg (18a, 18b) um etwa 90° abgebogene zweite Kontaktfahne (20; 20a, 20b) an dem Kontaktelement (13) ausgebildet ist, und dass die beiden Kontaktfahnen (14; 20; 20a, 20b) durch den wenigstens einen Verbindungssteg (18a, 18b) verbunden sind.

3. Kontaktsystem nach Anspruch 2, **dadurch gekennzeichnet, dass** der wenigstens eine Verbindungssteg (18a, 18b) zickzackförmig oder gerade verlaufend zwischen der ersten Kontaktfahne (14) und der zweiten Kontaktfahne (20; 20a, 20b) angeordnet ist.

4. Kontaktsystem nach Anspruch 2 oder 3, **dadurch gekennzeichnet, dass** an der ersten Kontaktfahne (14) Rastvorsprünge (17a, 17b) angeordnet sind, die von den Kontaktvorsprüngen (16a, 16b) mit ihrem freien Ende wegweisen.

5. Kontaktsystem nach einem der Ansprüche 2, 3 oder 4, **dadurch gekennzeichnet, dass** die zweite Kontaktfahne (20) aus zwei parallelen, um 90° abgebogene Kontaktlappen (20a, 20b) gebildet ist, und dass zwischen den beiden Kontaktlappen (20a, 20b) eine Rastfläche (22) und/oder beiderseits der beiden Kontaktlappen (20a, 20b) sowie von diesen mit ihrem freien Ende wegweisende Rastvorsprünge (21a, 21b) angeordnet sind.

6. Kontaktsystem nach einem der Ansprüche 2 bis 5, **dadurch gekennzeichnet, dass** die wenigstens einteilige zweite Kontaktfahne (20; 20a, 20b) dazu eingerichtet ist, die Leiterplatte (5) durch Einpressen oder Löten zu kontaktieren.

7. Kontaktsystem nach einem der Ansprüche 2 bis 6, **dadurch gekennzeichnet, dass** an dem Kontaktelement (13) benachbart zur wenigstens einteiligen zweiten Kontaktfahne (20; 20a, 20b) eine Ausnehmung (19) zur Aufnahme eines Positionierzapfens (11) ausgebildet ist.

8. Kontaktsystem nach Anspruch 1, **dadurch gekennzeichnet, dass** die erste Kontaktfahne (14) und die wenigstens einteilige zweite Kontaktfahne (20; 20a, 20b) gleichsinnig um etwa 90° in Richtung zu der Leiterplatte (5) abgebogen sind.

9. Kontaktsystem nach Anspruch 1, **dadurch gekennzeichnet, dass** die erste Kontaktfahne (14) entgegengesetzt zur wenigstens einteiligen zweiten Kontaktfahne ((20; 20a, 20b) um etwa 90° entgegensetzt zur Leiterplatte (5) abgebogen ist.

## Claims

1. A contact system for plug-in connections on electronics housings (1) for making contact with mechatronic components, for example control modules, solenoid valves, sensors or safety mechanisms of motor vehicles, having a base plate (2) of the electronics housing and having at least one contact element (13) which is in the form of a punched part, with which contact is made on a printed circuit board (5) and which is routed out of an electronic housing (1), wherein the at least one contact element (13) is designed
a) to be fastened to the base plate (2) of the electronics housing (1) by insertion and latching,
b) to make contact with a plug-in contact (23) of a mechatronic component by way of a first contact lug (14), and
c) to make contact with the printed circuit board (5) by way of a second contact lug (20; 20a, 20b), **characterized in that** the base plate (2) has a contact holder (9) for receiving a first contact lug (14) of the contact element (13), said contact holder being arranged on a face of the base plate (2) which is opposite to an insertion bevel (8) for a plug-in contact (23), **in that** a first pull-out prevention means (10) is arranged on the base plate (2) adjacent to said contact holder, the latching projections (25, 26) of said pull-out prevention means extending over the latching projections (17a, 17b) on the first contact lug (14), and **in that** a second pull-out prevention means (12) with at least one latching catch (12a) is formed on the base plate (2) for the second contact lug (20; 20a, 20b) of the contact element (13), said latching catch extending over the latching area (22) and/or the two latching projections (21a, 21b) on the second contact lug (20; 20a, 20b).

2. Contact system according to Claim 1, **characterized in that** the at least one contact element (13) has at least one connecting web (18a, 18b), **in that** a first contact lug (14) which is bent away through approximately 90° and has a cutout (15) is formed on the contact element (13) in relation to the at least one connecting web (18a, 18b), **in that** contact projections (16a, 16b) which project into the cutout (15) are formed on the first contact lug (14), **in that** at least one second contact lug (20; 20a, 20b) which is bent away through approximately 90° in relation to the at least one connecting web (18a, 18b) is formed on the contact element (13), and **in that** the two contact lugs (14; 20; 20a, 20b) are connected by the at least one connecting web (18a, 18b).

3. Contact system according to Claim 2, **characterized in that** the at least one connecting web (18a, 18b) is arranged so as to run in a zigzag manner or in a straight line between the first contact lug (14) and the second contact lug (20; 20a, 20b).

4. Contact system according to Claim 2 or 3, **characterized in that** latching projections (17a, 17b) which, by way of their free end, point away from the contact projections (16a, 16b) are arranged on the first contact lug (14).

5. Contact system according to one of Claims 2, 3 and 4, **characterized in that** the second contact lug (20) is formed from two parallel contact tabs (20a, 20b) which are bent away through 90°, and **in that** a latching area (22) is arranged between the two contact tabs (20a, 20b) and/or latching projections (21a, 21b) which, by way of their free end, point away from the two contact tabs (20a, 20b) are arranged on either side of said two contact tabs.

6. Contact system according to one of Claims 2 to 5, **characterized in that** the at least one-piece second contact lug (20; 20a, 20b) is designed to make contact with the printed circuit board (5) by pressing-in or soldering.

7. Contact system according to one of Claims 2 to 6, **characterized in that** a recess (19) for receiving a positioning pin (11) is formed on the contact element (13) adjacent to the at least one-piece second contact lug (20; 20a, 20b).

8. Contact system according to Claim 1, **characterized in that** the first contact lug (14) and the at least one-piece second contact lug (20; 20a, 20b) are bent away through approximately 90° in the direction toward the printed circuit board (5) in the same sense.

9. Contact system according to Claim 1, **characterized in that** the first contact lug (14) is bent away through approximately 90° opposite to the printed circuit board (5) opposite to the at least one-piece second contact lug (20; 20a, 20b).

## Revendications

1. Système de contact pour connexions par enfichage sur des boîtiers électroniques (1) servant à la mise en contact de composants mécatroniques, par exemple de modules de commande, d'électrovannes, de capteurs ou de fusibles de véhicules automobiles, avec une plaque de base (2) du boîtier électronique et comprenant au moins un élément de contact (13) réalisé sous la forme d'une pièce emboutie, qui vient en contact au niveau d'un circuit imprimé (5) et sortant d'un boîtier électronique (1), l'au moins un élément de contact (13) étant configuré pour
a) être fixé à la plaque de base (2) du boîtier électronique (1) par enfichage et enclipsage,
b) venir en contact avec un contact à enfichage (23) d'un composant mécatronique par une première languette de contact (14) et
c) venir en contact avec le circuit imprimé (5) par une deuxième languette de contact (20 ; 20a, 20b), **caractérisé en ce que** la plaque de base (2), pour accueillir une première languette de contact (14) de l'élément de contact (13), possède un porte-contact (9) qui est disposé sur un côté de la plaque de base (2) se trouvant à l'opposé d'un bord biseauté d'introduction (8) pour un contact à enfichage (23), **en ce qu'**un premier blocage anti-extraction (10) est disposé à côté de cela sur la plaque de base (2), les parties saillantes d'enclipsage (25, 26) duquel s'étendent sur les parties saillantes d'enclipsage (17a, 17b) au niveau de la première languette de contact (14), et **en ce qu'**un deuxième blocage anti-extraction (12) comprenant au moins un tenon d'enclipsage (12a) est formé au niveau de la plaque de base (2) pour la deuxième languette de contact (20 ; 20a, 20b) de l'élément de contact (13), lequel s'étend sur la surface d'enclipsage (22) et/ou sur les deux parties saillantes d'enclipsage (21a, 21b) au niveau de la deuxième languette de contact (20 ; 20a, 20b).

2. Système de contact selon la revendication 1, **caractérisé en ce que** l'au moins un élément de contact (13) possède au moins une âme de liaison (18a, 18b), **en ce qu'**une première languette de contact (14) munie d'une découpe (15) et coudée d'environ 90° est formée au niveau de l'élément de contact (13) en référence à l'au moins une âme de liaison (18a, 18b), **en ce que** des parties saillantes de contact (16a, 16b) sont formées au niveau de la première languette de contact (14), lesquelles pénètrent dans la découpe (15), **en ce qu'**au moins une deuxième languette de contact (20 ; 20a, 20b) coudée d'environ 90° est formée au niveau de l'élément de contact (13) en référence à l'au moins une âme de liaison (18a, 18b), et **en ce que** les deux languettes de contact (14 ; 20 ; 20a, 20b) sont reliées par l'au moins une âme de liaison (18a, 18b).

3. Système de contact selon la revendication 2, **caractérisé en ce que** l'au moins une âme de liaison (18a, 18b) est disposée en forme de zigzag ou en ligne droite entre la première languette de contact (14) et la deuxième languette de contact (20 ; 20a, 20b).

4. Système de contact selon la revendication 2 ou 3, **caractérisé en ce que** des parties saillantes d'enclipsage (17a, 17b) sont disposées au niveau de la première languette de contact (14), lesquelles s'éloignent des parties saillantes de contact (16a, 16b) avec leur extrémité libre.

5. Système de contact selon l'une des revendications 2, 3 ou 4, **caractérisé en ce que** la deuxième languette de contact (20) est formée par deux lobes de contact (20a, 20b) parallèles coudés de 90°, et **en ce qu'**une surface d'enclipsage (22) est disposée entre les deux lobes de contact (20a, 20b) et/ou des parties saillantes d'enclipsage (21a, 21b) sont disposées des deux côtés des deux lobes de contact (20a, 20b), lesquelles s'éloignent également de ceux-ci par leur extrémité libre.

6. Système de contact selon l'une des revendications 2 à 5, **caractérisé en ce que** la deuxième languette de contact (20 ; 20a, 20b) au moins monobloc est conçue pour venir en contact avec le circuit imprimé (5) par enfoncement ou brasage.

7. Système de contact selon l'une des revendications 2 à 6, **caractérisé en ce qu'**une cavité (19) destinée à accueillir un tenon de positionnement (11) est formée au niveau de l'élément de contact (13), de manière adjacente à la deuxième languette de contact (20 ; 20a, 20b) au moins monobloc.

8. Système de contact selon la revendication 1, **caractérisé en ce que** la première languette de contact (14) et la deuxième languette de contact (20 ; 20a, 20b) au moins monobloc sont coudées d'environ 90° dans le même sens en direction du circuit imprimé (5).

9. Système de contact selon la revendication 1, **caractérisé en ce que** la première languette de contact (14), contrairement à la deuxième languette de contact (20 ; 20a, 20b) au moins monobloc, est coudée d'environ 90° à l'opposé du circuit imprimé (5).
